# EUROPEAN PATENT APPLICATION

(11) **EP 4 668 576 A1**
(43) Date of publication of application: **24.12.2025**
(21) Application number: 24210532.8
(22) Date of filing: 04.11.2024
(51) Int. Cl.: H02S 50/10

(54) **SHUTDOWN DEVICE, CONTROL METHOD FOR SHUTDOWN DEVICE, AND PHOTOVOLTAIC SYSTEM**

(30) Priority: 19.06.2024 CN 202410797782
(71) Applicant: Sunshare Power Technology Co., Ltd., Nanjing Jiangsu 211153 (CN)
(72) Inventor: HE, Peng, Nanjing, 211153 (CN); KANG, Ming, Nanjing, 211153 (CN); CHEN, Lei, Nanjing, 211153 (CN); ZHENG, Benben, Nanjing, 211153 (CN); ZHANG, Yuehuo, Nanjing, 211153 (CN)
(74) Representative: Rooney, John-Paul

(57) **Abstract**

A shutdown device, a control method for the shutdown device and a photovoltaic system are disclosed in the present disclosure, which relates to the technical field of photovoltaic power generation. The shutdown device is arranged corresponding to a photovoltaic module, where the photovoltaic module is configured to supply power to a load. The shutdown device includes: a switching circuit, a sampling-monitoring circuit and a drive circuit; where the switching circuit is arranged in a load circuit comprising the photovoltaic module and the load, and connected to the drive circuit; the sampling-monitoring circuit is assigned to the photovoltaic module, the load and the drive circuit, configured to sample a first voltage of the photovoltaic module, a second voltage of the load; and when a bus is determined short-circuited based on the first voltage and the second voltage, the switching circuit is controlled to be turned off through the drive circuit to disconnect the load circuit. The shutdown device determines the short circuit condition of the photovoltaic module by monitoring the voltage of the photovoltaic module and the load, and disconnects the photovoltaic module from the load when it is determined that the short circuit occurs, thereby achieving effective and reliable short circuit protection and low cost.

## Description

### FIELD

The present disclosure relates to the technical field of photovoltaic power generation, in particular to a shutdown device, a control method for a shutdown device, and a photovoltaic system.

### BACKGROUND

At present, a short circuit on a photovoltaic line is generally determined based on a sampling current, and a shutdown device in a circuit is controlled to turn on or turn off based on the determination result. However, this technique has the problems as follows.

When the line is short-circuited, a difference between a short-circuit current and a comparison threshold is small, which easily leads to misdiagnosis. In addition, it is required for a high-precision sampling, resulting in a high cost of a sampling device.

Different photovoltaic modules have different sampling currents. Thus, the different photovoltaic modules have different comparison thresholds under different illumination conditions, such that a unified comparison threshold cannot be obtained.

If the short circuit occurs between adjacent photovoltaic modules, current cannot be sampled since that positive current and negative current may be in the line at the same time. Thus, the short circuit cannot be determined.

If the sampling current is the line bus current, the short circuit situation of each photovoltaic module in the line cannot be determined.

### SUMMARY

The present disclosure aims to solve at least one of the technical problems in the related art in some degree. In view of this, a shutdown device, a control method for the shutdown device and a photovoltaic system are provided in the present disclosure, to provide an effective and reliable short circuit protection and lower the cost.

In order to solve the above problems, in a first aspect of the present disclosure, a shutdown device is provided in an embodiment of the present disclosure. The shutdown device is provided for a corresponding photovoltaic module, where the photovoltaic module is configured to supply power to a load, and the shutdown device includes: a switching circuit, a sampling-monitoring circuit and a drive circuit; where the switching circuit is arranged in a load circuit including the photovoltaic module and the load, and connected to the drive circuit; the sampling-monitoring circuit is connected to the photovoltaic module, the load and the drive circuit, the sampling-monitoring circuit is configured to sample a first voltage of the photovoltaic module, a second voltage of the load; and to control the switching circuit to be turned off through the drive circuit to disconnect the photovoltaic module with the load, in response to determining a short circuit of a bus based on the first voltage and the second voltage.

In addition, the shutdown device according to the embodiment of the present disclosure may have the technical features as below.

According to one embodiment of the present disclosure, the shutdown device further includes: an auxiliary source circuit connected to the photovoltaic module and the drive circuit, and configured to output a steady auxiliary voltage in a case that the photovoltaic module operates normally, and keep outputting the auxiliary voltage in the case of the short circuit of the bus; where the drive circuit, after controlling the switching circuit to be turned off, is further configured to keep the switching circuit in an off state under the auxiliary voltage.

According to one embodiment of the present disclosure, the shutdown device further includes: a reset circuit connected with the auxiliary source circuit; where the auxiliary source circuit is configured to discharge the auxiliary voltage in a reset process of the reset circuit; and the sampling-monitoring circuit is connected to the auxiliary source circuit, and configured to sample a third voltage output by the auxiliary source circuit and control the switching circuit to be turned on by the drive circuit to connect the photovoltaic module with the load, in response to determining from the third voltage that the auxiliary source circuit is reset.

According to one embodiment of the present disclosure, the sampling-monitoring circuit is configured to, in response to determining from the third voltage that the auxiliary source circuit is reset, control the switching circuit to be turned off after turned on instantaneously by the drive circuit, in a case that the short circuit of the bus determined based on the first voltage and the second voltage is unrelieved; and keep the switching circuit in an on state by the drive circuit, in a case that the short circuit of the bus is determined to be relieved.

According to one embodiment of the present disclosure, the switching circuit includes a switching transistor; a control terminal of the switching transistor is connected with the drive circuit, a second terminal of the switching transistor is connected with a positive terminal of the photovoltaic module and a first terminal of the switching transistor is connected with a positive terminal of the load; alternatively, a first terminal of the switching transistor is connected with a negative terminal of the photovoltaic module and a second terminal of the switching transistor is connected with a negative terminal of the load.

According to one embodiment of the present disclosure, the sampling-monitoring circuit includes: a first voltage sampling unit connected with the photovoltaic module, and configured to sample the first voltage; a second voltage sampling unit connected with the load, and configured to sample the second voltage; a third voltage sampling unit connected with the auxiliary source circuit, and configured to sample the third voltage; a first comparator connected with the first sampling unit, configured to compare the first voltage with a target voltage threshold and output a first comparison signal based on a first compared result; a second comparator connected with the second sampling unit, configured to compare the second voltage with the target voltage threshold and output a second comparison signal based on a second compared result; a third comparator connected with the third sampling unit, configured to compare the third voltage with the target voltage threshold and output a third comparison signal based on a third compared result; a logical unit, connected to the first comparator, the second comparator, the third comparator and the drive circuit, and configured to output a first level signal to the drive circuit to control the switching circuit to be turned off by the drive circuit in response to determining a short-circuit in the photovoltaic module based on the first comparison signal, the second comparison signal and the third comparison signal, or in response to determining that the short-circuit in the photovoltaic module is relieved and the auxiliary source circuit is not reset; and output a second level signal to the drive circuit to control the switching circuit to be turned on by the drive circuit, in response to determining that the short circuit of the bus is relieved and the auxiliary source circuit is reset based on the first comparison signal, the second comparison signal and the third comparison signal.

According to one embodiment of the present disclosure, the logical unit includes: a first AND gate, a second AND gate, an inverter, and an SR trigger; the first AND gate includes a first input terminal connected to an output terminal of the first comparator, a second input terminal connected to an output terminal of the second comparator, and an output terminal connected to an S terminal of the SR trigger; the second AND gate includes a first input terminal connected to the output terminal of the first comparator, a second input terminal connected to an output terminal of the third comparator, an output terminal connected to an input terminal of the inverter, an output terminal of the inverter is connected to an R terminal of the SR trigger, and a Q terminal of the SR trigger is connected to the drive circuit.

According to one embodiment of the present disclosure, the sampling-monitoring circuit further includes: a voltage stabilizer, a first resistor, a second resistor and a third resistor, where a first terminal of the first resistor is connected to a second terminal of the third resistor and a cathode of the voltage stabilizer, a first terminal of the third resistor is connected to the auxiliary source circuit, a second terminal of the first resistor is connected to a first terminal of the second resistor and a reference terminal of the voltage stabilizer, and a second terminal of the second resistor is connected to an anode of the voltage stabilizer and is grounded, where the cathode of the voltage stabilizer is configured to output the target voltage threshold.

To solve the above technical problem, a control method for a shutdown device is provided in a second aspect of the present disclosure. In the method, the shutdown device is applied to a corresponding photovoltaic module, and arranged in a load circuit comprising the photovoltaic module and a load, and the method includes: controlling the shutdown device to be turned off to disconnect the photovoltaic module with the load, in response to determining a short circuit of a bus based on a first voltage of the photovoltaic module and a second voltage of the load.

In addition, the control method for the shutdown device according to the embodiments of the present disclosure may have the technical features as below.

According to an embodiment of the present disclosure, after controlling the shutdown device to be turned off, the method further includes: controlling the shutdown device to be turned on to connect the photovoltaic module with the load, in a case that the short circuit of the bus is relieved and the auxiliary source circuit is reset.

According to an embodiment of the present disclosure, after controlling the shutdown device to be turned off, the method further includes: turning on the switching circuit instantaneously and turning off the shutdown device, in a case that the short circuit of bus is unrelieved and the auxiliary source circuit in the shutdown device is reset.

In order to solve the above technical problems, a photovoltaic system is provided in a third aspect of the present disclosure. The photovoltaic system includes: a photovoltaic module, a load, and the shutdown device described in the embodiments of the first aspect.

A shutdown device, a control method for a shutdown device, and a photovoltaic system are provided in the embodiments of the present disclosure, which determines the short circuit condition of the photovoltaic module by monitoring the voltage of the photovoltaic module and the load, and disconnects the photovoltaic module with the load when it is determined that the short circuit occurs, thereby providing an effective and reliable short circuit protection and lowering the cost.

### BRIEF DESCRIPTION OF THE DRAWINGS

FIG. 1(a) is a schematic structural diagram illustrating a photovoltaic system according to an embodiment of the present disclosure;
FIG. 1(b) is a schematic structural diagram illustrating a photovoltaic system according to another embodiment of the present disclosure;
FIG. 2 is a schematic structural diagram of a shutdown device according to a first embodiment of the present disclosure;
FIG. 3 is a schematic structural diagram of a shutdown device according to a second embodiment of the present disclosure;
FIG. 4 is a schematic structural diagram of a shutdown device according to a third embodiment of the present disclosure;
FIG. 5 is a schematic structural diagram of a shutdown device according to a fourth embodiment of the present disclosure;
FIG. 6 is a schematic structural diagram of a shutdown device according to a fifth embodiment of the present disclosure;
FIG. 7 is a schematic structural diagram of a shutdown device according to a sixth embodiment of the present disclosure;
FIG. 8 is a schematic structural diagram of a sampling-monitoring circuit according to an embodiment of the present disclosure;
FIG. 9 is a schematic structural diagram of a logical unit according to an embodiment of the present disclosure;
FIG. 10 is a schematic structural diagram of a sampling-monitoring circuit according to another embodiment of the present disclosure;
FIG. 11 is a timing diagram of an operation of a shutdown device according to an embodiment of the present disclosure;
FIG. 12 (a) is a simulation waveform diagram of the shutdown device in operation according to a first embodiment of the present disclosure;
FIG. 12 (b) is a simulation waveform diagram of a shutdown device in operation according to a second embodiment of the present disclosure;
FIG. 12 (c) is a simulation waveform diagram of a shutdown device in operation according to a third embodiment of the present disclosure;
FIG. 13 is a flowchart of a control method for a shutdown device according to an embodiment of the present disclosure; and
FIG. 14 is a structural block diagram of a photovoltaic system according to an embodiment of the present disclosure.

### Reference numerals are described as follows.

| | | | |
|---|---|---|---|
| 100 | Shutdown device | 200 | Photovoltaic module |
| 300 | Load | | |
| 110 | Switching circuit | 120 | Sampling-monitoring circuit |
| 130 | Drive circuit | 140 | Auxiliary source circuit |
| 150 | Reset circuit | 121 | First voltage sampling unit |
| 122 | Second voltage sampling unit | 123 | Third voltage sampling unit |
| 124 | First comparator | 125 | Second comparator |
| 126 | Third comparator | 127 | Logical unit |
| 128 | Voltage stabilizer | 1271 | First AND gate |
| 1272 | Second AND gate | 1273 | Inverter |
| 1274 | SR trigger | R1 | First resistor |
| R2 | Second resistor | | |

### DETAILED DESCRIPTION

The embodiments of the present disclosure are described in detail hereinafter, and examples of the embodiments are shown in drawings, in which the same or similar reference numerals represent the same or similar members or members having the same or similar functions throughout the description. The embodiments described below with reference to the drawings are only exemplary embodiments which are used to explain the present disclosure, and should not be understood to limit the present disclosure.

A shutdown device, a control method for the shutdown device, and a photovoltaic system according to embodiments of the present disclosure are described in the following with reference to the drawings.

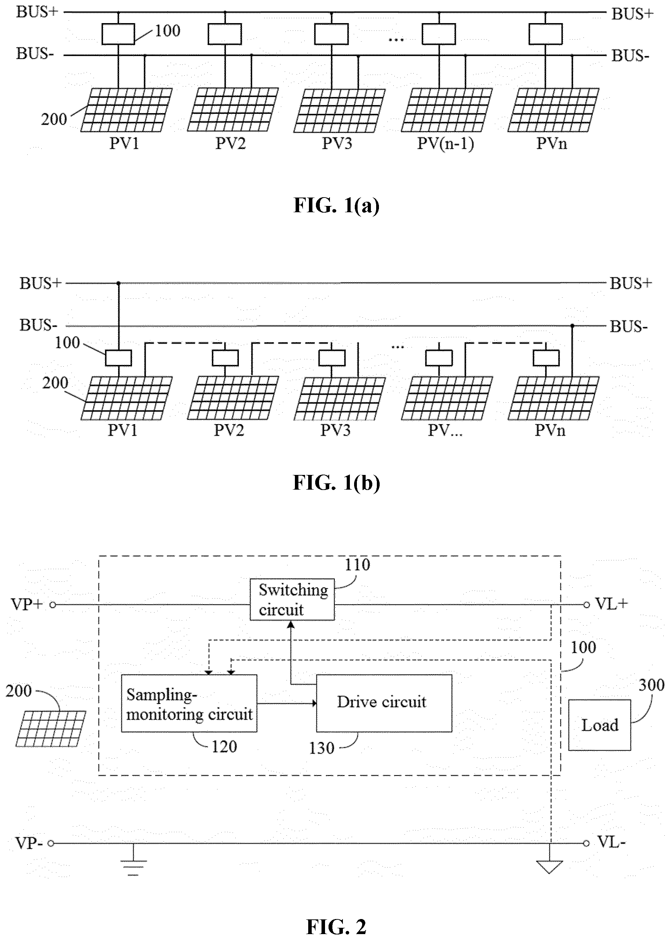

In an embodiment of the present disclosure, as shown in FIG. 1(a) and FIG. 1(b), the shutdown device 100 is provided for a corresponding photovoltaic module 200. The photovoltaic module 200 is configured to supply power to the load 300 (not shown in FIG. 1 (a) and FIG. 1 (b)). In a photovoltaic system including multiple photovoltaic modules 200 (FIG. 1(a) shows multiple photovoltaic modules 200 connected in parallel, FIG. 1(b) shows multiple photovoltaic modules 200 connected in series), photovoltaic modules may be provided with respective shutdown devices 100. Each shutdown device 100 may be connected to a positive terminal or a negative terminal of the corresponding photovoltaic module 200 (FIG. 1(a) and FIG. 1(b) both show an example that the shutdown device 100 is connected to the positive terminal). In this way, short-circuit determination and short-circuit protection control for each photovoltaic module 200 can be implemented. The load 300 may include, but be not limited to, a photovoltaic inverter. In FIG. 1(a) and FIG. 1(b), BUS+ represents a positive bus, and BUS- represents a negative bus.

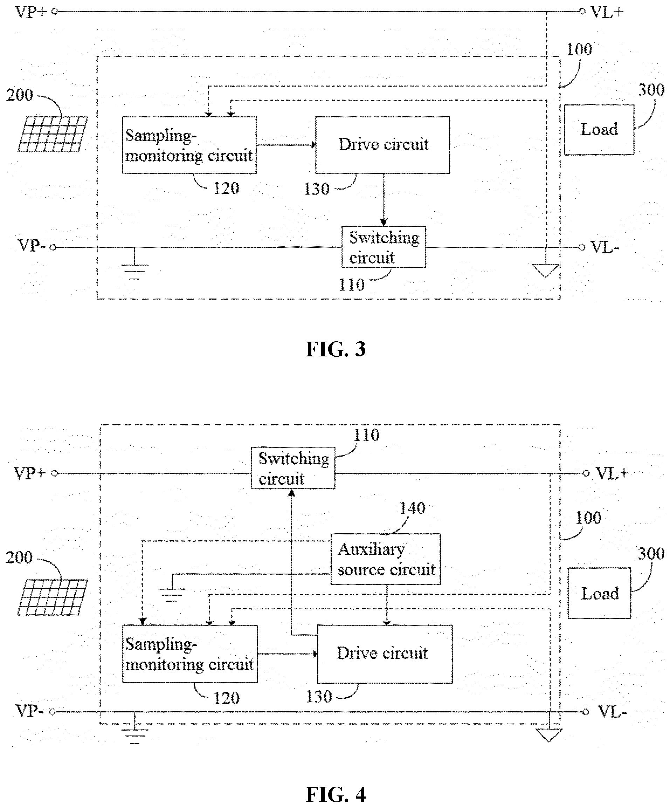

As shown in FIG. 2 and FIG. 3, the shutdown device 100 includes a switching circuit 110, a sampling-monitoring circuit 120, and a drive circuit 130.

The switching circuit 110 is connected to a load circuit including the photovoltaic module 200 and the load 300, and is connected to the drive circuit 130.

FIG. 2 shows an example of the switching circuit 110 connected to the positive terminal of the photovoltaic module 200, and FIG. 3 shows an example of the switching circuit 110 connected to the negative terminal of the photovoltaic module 200. The sampling-monitoring circuit 120 is connected to the photovoltaic module 200, the load 300 and the drive circuit 130. The sampling-monitoring circuit 120 is configured to sample a first voltage of the photovoltaic module 200, a second voltage of the load 300; and to control the switching circuit to be turned off through the drive circuit to disconnect the photovoltaic module with the load, in response to determining that a bus of the photovoltaic module 200 is short-circuited based on the first voltage and the second voltage. For example, if the first voltage is reduced to a constant value and then rise, and the second voltage is reduced to 0, it is determined to short-circuit the bus of the photovoltaic module 200.

The short circuit of the photovoltaic module 200 is determined by arranging the shutdown device 100 corresponding to the photovoltaic module 200, and specifically monitoring the voltage of the source side (the photovoltaic module 200) and the voltage of the load side (the load 300) through the sampling-monitoring circuit 120. In response to determining to short-circuit the bus of the photovoltaic module 200, the switching circuit 110 connected to the load circuit is controlled to be turned off, such that the load circuit is broken, and short-circuit protection is achieved. The protection mode for monitoring short circuit may be applied to various short-circuit conditions, and is not limited by a short-circuit position, such as a short circuit operation condition of any one or more photovoltaic modules 200 in a photovoltaic system or a short circuit operation condition of a bus shown in FIG. 1(a) and FIG. 1(b). In addition, the voltage of the photovoltaic module 200 and the voltage of the load 300 when the load circuit normally operates differ from those when the bus of the photovoltaic module 200 is short-circuited. Thus, it is required that the sampling-monitoring circuit 120 has a low precision, the cost thereof is low, the reliability of short circuit determination is high, and the misdiagnosis rate is low.

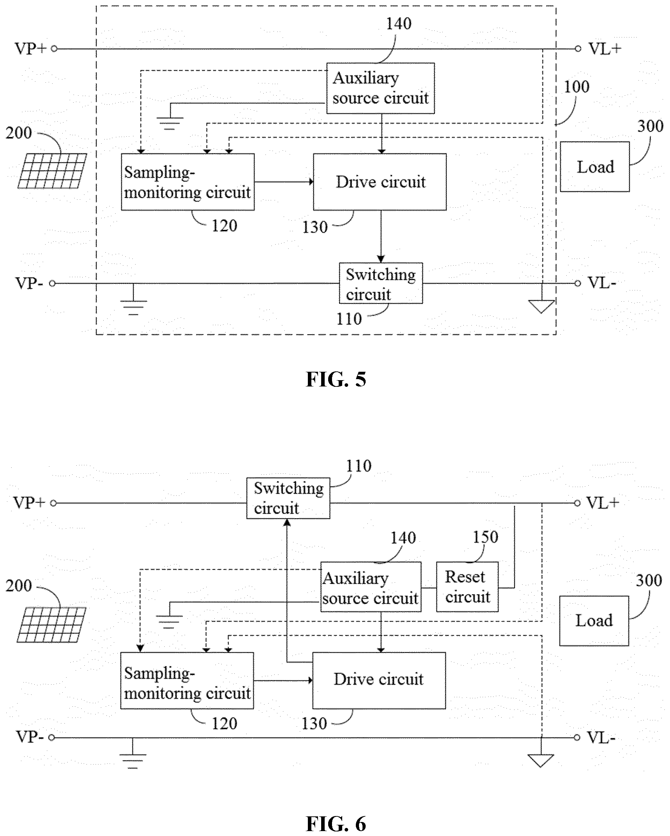

In some embodiments of the present disclosure, as shown in FIG. 4 and FIG. 5, the shutdown device 100 further includes: an auxiliary source circuit 140. The auxiliary source circuit 140 is connected to the photovoltaic module 200 and the drive circuit 130. The auxiliary source circuit 140 is configured to output a stable auxiliary voltage Vaux when the photovoltaic module 200 operates normally, and keep outputting the auxiliary voltage when the bus of the photovoltaic module 200 is short-circuited.

In this embodiment, after controlling the switching circuit 110 to be turned off, the drive circuit 130 is further configured to keep the switching circuit 110 in an off state under the auxiliary voltage. That is, a driving locking function for the switching circuit 110 is achieve, so as to improve the reliability of short-circuit protection.

In this embodiment, the auxiliary source circuit 140 may include an auxiliary source and a delay holding unit. The auxiliary source is configured to output a stable auxiliary voltage Vaux after the photovoltaic module 200 starts to work. The delay holding unit may delay the output of the auxiliary voltage Vaux, such that the auxiliary source circuit 140 may be started with delay after the voltage of the load 300 rises. When the bus of the photovoltaic module 200 is short-circuited, the auxiliary source circuit 140 keeps the output of the auxiliary voltage Vaux, to drive and lock the switching circuit 110 to realize reliable protection of the short circuit.

It should be noted that, in a process of starting the photovoltaic module 200, the voltage of the photovoltaic module is established first. At this time, the voltage of the load is not established or is in the established process (at this time, the voltage of the load is a low voltage). The auxiliary source is turned on with delay. The load voltage is established, and the voltage of the auxiliary source is a low voltage before the auxiliary source is turned on with delay. Thus, it can be effectively prevented misdiagnosis of a short circuit of the photovoltaic module 200 in the starting process, which may cause the photovoltaic module 200 to fail to start up.

The delay holding unit may include one or more capacitors. In the case of multiple capacitors, the multiple capacitors may be connected in parallel. The delay holding unit may also include a resistor. For example, the delay holding unit may be an RC delay circuit.

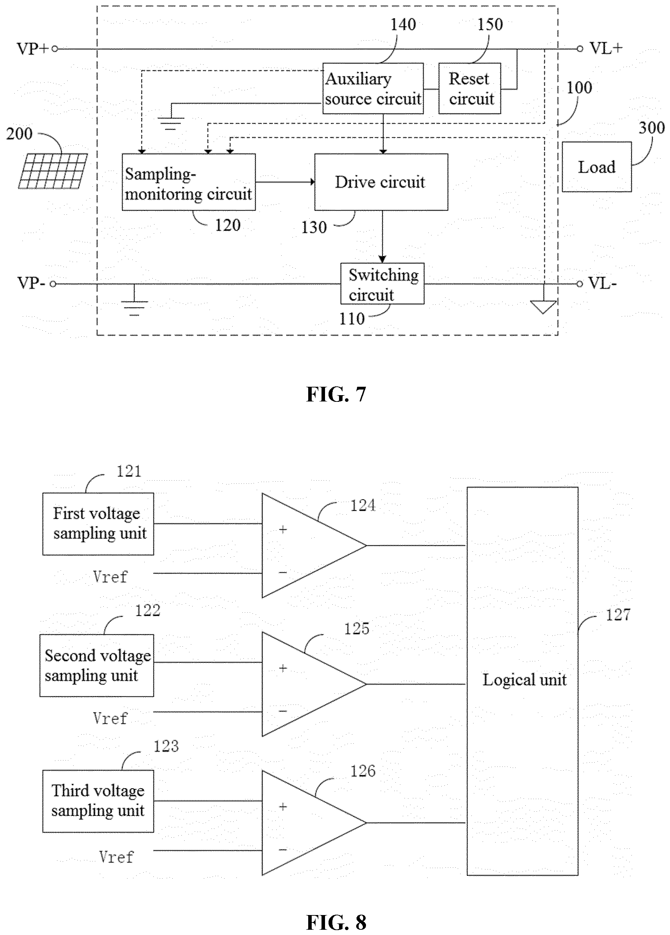

In some embodiments of the present disclosure, as shown in FIG. 6 and FIG. 7, the shutdown device 100 further includes a reset circuit 150 connected to the auxiliary source circuit 140.

The auxiliary source circuit 140 is configured to discharge the auxiliary voltage Vaux when the reset circuit 150 is reset. The sampling-monitoring circuit 120 is connected to the auxiliary source circuit 140. The sampling-monitoring circuit 120 is configured to sample a third voltage output by the auxiliary source circuit 140; and to control the switching circuit 110 to be turned on by the drive circuit 130 to connect the photovoltaic module with the load, in response to determining that the auxiliary source circuit 140 is reset based on the third voltage (for example, the third voltage is reduced to a certain threshold).

In an embodiment, the reset circuit 150 may include a reset button or a reset switch. Once the reset button or the reset switch is triggered (for example, the reset button or the reset switch is pressed, that is, the reset circuit 150 performs a reset operation), a connection between the auxiliary source circuit 140 and the discharge circuit may be established. The discharge circuit may be a circuit including the load 300. That is, the reset circuit 150 may be connected between the auxiliary source circuit 140 and the load 300. After the reset circuit 150 performs the reset operation, the auxiliary source circuit 140 may provide the output voltage to the load 300, to discharge the voltage of the auxiliary source circuit 140. The discharge circuit may also be an additional circuit which is configured to implement discharging of the auxiliary source circuit 140. Compared with the additional arrangement, the device in the shutdown device 100 can be reduced and the cost can be saved, by directly using the load 300 to discharge the auxiliary source circuit 140. The reset operation of the reset circuit 150 may be manually triggered. For example, the user manually presses the reset switch according to needs, or manually and remotely controls the reset circuit 150 to operate according to needs.

In some examples, the sampling-monitoring circuit 120 is configured to, in response to determining that the auxiliary source circuit 140 is reset based on the third voltage, turning on the switching circuit instantaneously and then turn off the switching circuit 110 by the drive circuit 130, in a case that the bus of the photovoltaic module 200 determined based on the first voltage and the second voltage is unrelieved; and keep the switching circuit 110 in an on state by the drive circuit, in a case that short circuit of the bus is determined to be relieved.

In some embodiments of the present disclosure, the switching circuit 110 includes a switching transistor. A control terminal of the switching transistor is connected with the drive circuit 130. A second terminal of the switching transistor is connected with a positive terminal of the photovoltaic module 200 and a first terminal of the switching transistor is connected with a positive terminal of the load 300. Alternatively, a first terminal of the switching transistor is connected with a negative terminal of the photovoltaic module 200 and a second transistor of the switching transistor is connected with a negative terminal of the load 300.

The switching transistor may be a Metal-Oxide-Semiconductor Field-Effect Transistor (MOS) transistor, a triode, or an Insulated Gate Bipolar Transistor (IGBT).

In some embodiments of the present disclosure, as shown in FIG. 8, the sampling-monitoring circuit includes: a first voltage sampling unit 121, a second voltage sampling unit 122, a third voltage sampling unit 123, a first comparator 124, a second comparator 125, a third comparator 126, and a logical unit 127.

The first voltage sampling unit 121 is connected to the photovoltaic module 200, and is configured to sample a first voltage Vpv. The second voltage sampling unit 122 is connected to the load 300, and is configured to sample a second voltage V1. The third voltage sampling unit 123 is connected to the auxiliary source circuit 140, and is configured to sample a third voltage Vaux. The first comparator 124 is connected to the first voltage sampling unit 121, and is configured to compare the first voltage Vpv with a target voltage threshold Vref, and output a first comparison signal based on a compared result. The second comparator 125 is connected to the second voltage sampling unit 122, and is configured to compare the second voltage V1 with the target voltage threshold Vref, and output a second comparison signal based on a compared result. The third comparator 126 is connected to the third voltage sampling unit 123, and is configured to compare the third voltage Vaux with the target voltage threshold Vref, and output a third comparison signal based on a compared result. The logical unit 127 is connected to the first comparator 124, the second comparator 125, the third comparator 126 and the drive circuit 130. The logical unit 127 is configured to output a first level signal (such as a low level signal) to the drive circuit 130 to control the switching circuit 110 to be turned off by the drive circuit 130, in response to determining a short circuit in the photovoltaic module 200 based on the first comparison signal, the second comparison signal and the third comparison signal, or in response to determining that the short circuit is relieved and the auxiliary source circuit 140 is not reset. The logical unit 127 is further configured to output a second level signal (such as a high level signal) to the drive circuit 130 to control the switching circuit 110 to be turned on by the drive circuit 130, in response to determining that the short circuit of the bus of the photovoltaic module 200 is relieved and the auxiliary source circuit is reset based on the first comparison signal, the second comparison signal and the third comparison signal.

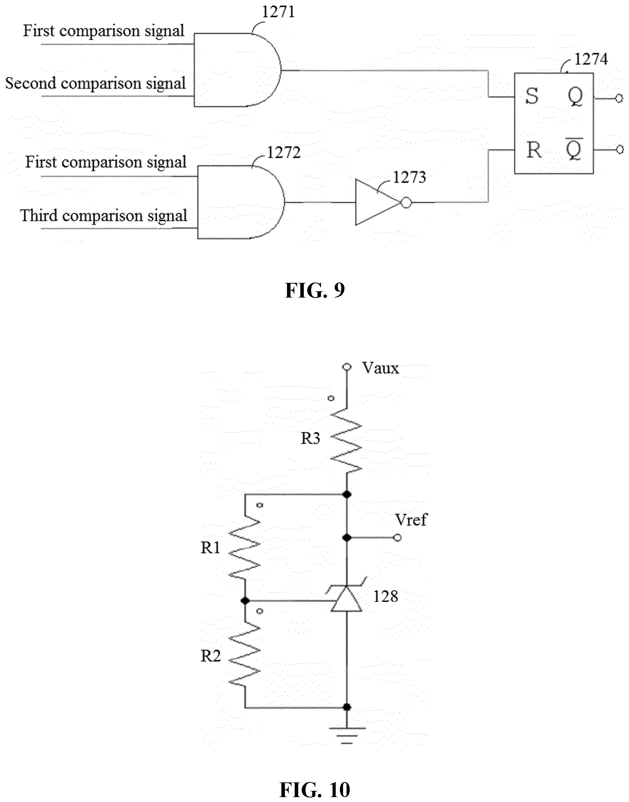

In an embodiment, as shown in FIG. 9, the logical unit 127 includes a first AND gate 1271, a second AND gate 1272, an inverter 1273, and an SR trigger 1274.

The first AND gate 1271 includes a first input terminal connected to an output terminal of the first comparator 124, a second input terminal connected to an output terminal of the second comparator 125, and an output terminal connected to an S terminal of the SR trigger 1274. The second AND gate 1272 includes a first input terminal connected to the output terminal of the first comparator 124, a second input terminal connected to an output terminal of the third comparator 126, an output terminal connected to an input terminal of the inverter 1273. An output terminal of the inverter 1273 is connected to an R terminal of the SR trigger 1274. A Q terminal of the SR trigger 1274 is connected to the drive circuit 130.

The implementation method of the logical unit 127 is not limited to the manner shown in FIG. 9, which may include another implementation manner.

In some embodiments of the present disclosure, as shown in FIG. 10, the sampling-monitoring circuit 120 further includes: a voltage stabilizer 128, a first resistor R1, a second resistor R2 and a third resistor R3. A first terminal of the first resistor R1 is connected to a second terminal of the third resistor R3 and a cathode of the voltage stabilizer 128. A first terminal of the third resistor R3 is connected to the auxiliary source circuit 140. A second terminal of the first resistor R1 is connected to a first terminal of the second resistor R2 and a reference terminal of the voltage stabilizer 128. A second terminal of the second resistor R2 is connected to an anode of the voltage stabilizer 128 and is grounded. The cathode of the voltage stabilizer 128 is configured to output the target voltage threshold Vref.

The voltage stabilizer128 may adopt an LM431 voltage stabilizing circuit, a TL431 voltage stabilizing circuit, and the like. As shown in FIG. 7, when the voltage across the second resistor R2 (determined based on the third voltage) is greater than the reference voltage of the voltage stabilizer 128, the target voltage threshold Vref is 0. When the voltage across the second resistor R2 is less than the reference voltage of the voltage stabilizer 128, the target voltage threshold Vref is Vaux.

In some embodiments of the present disclosure, the sampling-monitoring circuit 120 includes the first voltage sampling unit 121, the second voltage sampling unit 122, the third voltage sampling unit 123, and a processing unit. The processing unit may implement the functions of the first comparator 124, the second comparator 125, the third comparator 126, and the logical unit 127 by software.

In an embodiment of the present disclosure, the drive circuit 130 may be triggered and implement control functions on the switching circuit 110 through software. In this condition, the drive circuit 130 may be integrated with the processing unit, which is simple to implement. The drive circuit 130 may also be triggered and implement control functions on the switching circuit 110 through hardware. In this condition, the implementation has a rapid response and a low cost.

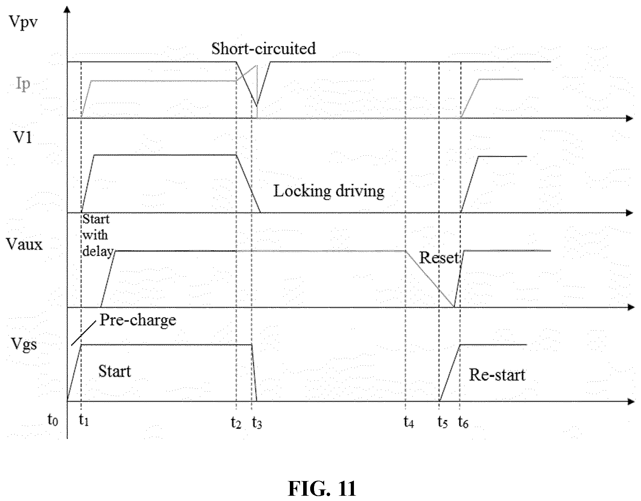

The operation process of the shutdown device 100 provided in the embodiment of the present disclosure is described in conjunction with FIG. 11. In FIG. 8, Vpv represents the voltage at the source side (i.e., the first voltage), Ip represents the current between the photovoltaic module 200 and the load 300, V1 represents the voltage at the load side (i.e., the second voltage), Vaux represents the output voltage (i.e., the third voltage) of the auxiliary source circuit 140, and Vgs represents a driving voltage of the switching transistor in the switching circuit 110.

As shown in FIG. 11, the operation process of the shutdown device 100 may be divided into the following 6 periods.

In a period from t0 to t1, the photovoltaic assembly 200 starts to operate, the auxiliary source circuit 140 is in a reset state, and the drive circuit 130 pre-charges the driving terminal of the switching transistor. In this period, Vgs gradually increases. At the time t1, the Vgs increases to a limit voltage of the switching transistor turning on, the switching transistor is turned on and the load circuit is connected to the photovoltaic assembly 200.

In a period from t1 to t2, the photovoltaic module 200 operates normally, and the V1 gradually rises since the load circuit is connected, until V1 reach a stable value. The auxiliary source circuit 140 is turned on with delay after the V1 rises, and outputs a stable voltage Vaux after being turned on.

In a period t2 to t3, a short circuit occurs in the photovoltaic module 200, Vpv and V1 decrease immediately, and Vaux is maintained. At the time t3, V1 drops to a certain voltage threshold, the drive circuit 130 controls the Vgs to start to decrease, to turn off the switching transistor. The load circuit is disconnected with the photovoltaic assembly 200, thereby achieving short circuit protection.

In a period t3 to t4, the source side is completely disconnected with the load side, Vpv is restored, Vaux remains unchanged, and the switching transistor is locked in the off state.

In a period t4 to t5, the reset circuit 150 performs a reset operation, the auxiliary source circuit 140 discharges, and the Vaux gradually decreases.

In a period t5 to t6, Vaux at a time t5 decreases to a certain threshold, Vgs starts to be pre-charged. At a time t6, Vgs is increased to the limit voltage of the switching transistor turning on again, the switching transistor is turned on again, and load 300 works again.

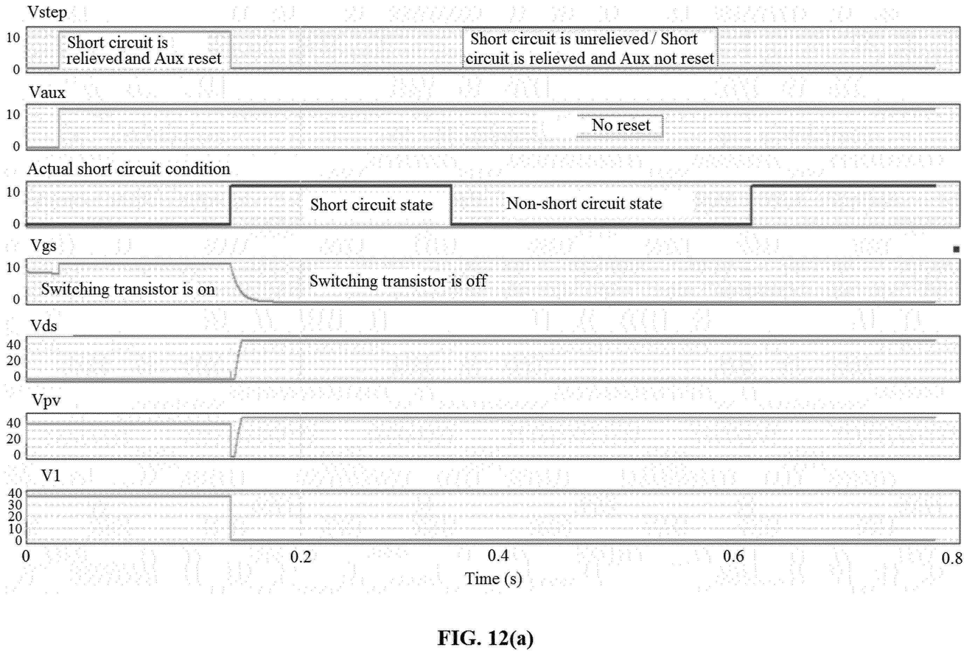

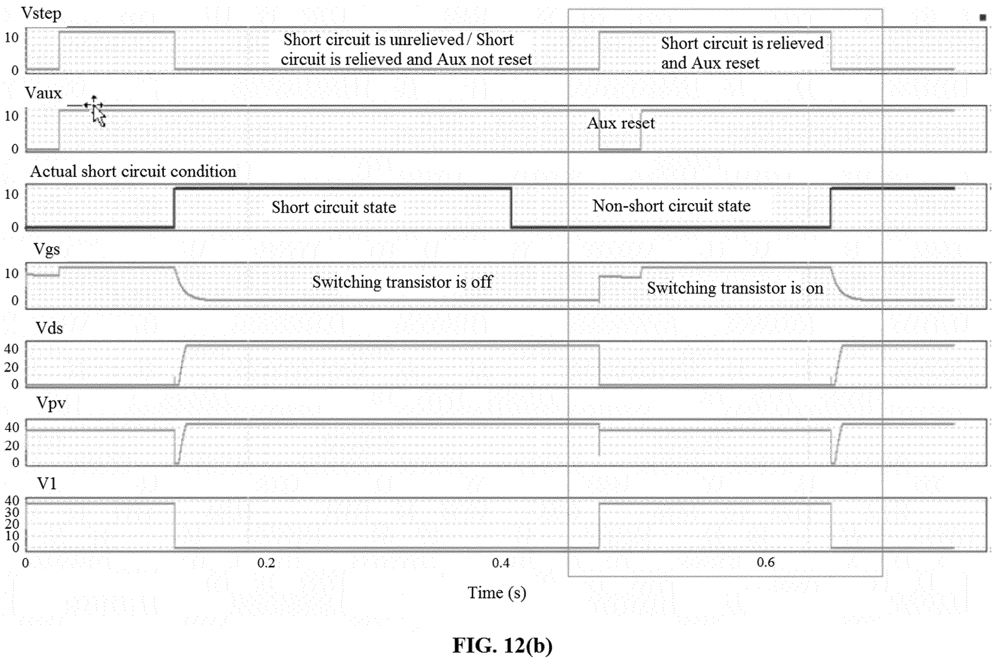

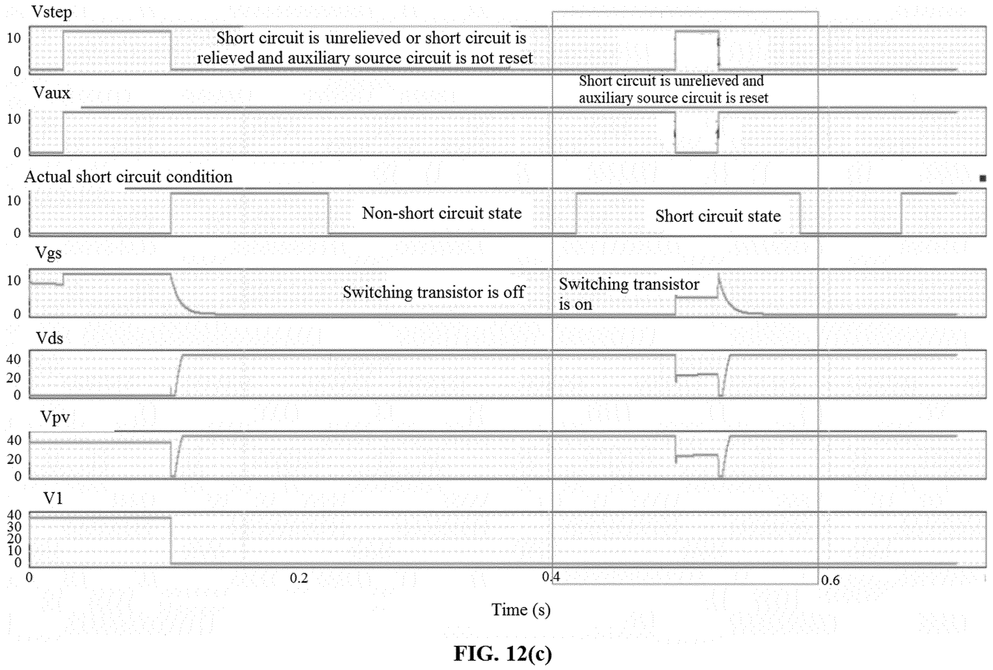

For ease of understanding, the operation process of the shutdown device according to the embodiment of the present disclosure in different short-circuit operating conditions is described below with reference to FIG. 12 (a), FIG. 12 (b), and FIG. 12 (c).

FIG. 12 (a) shows an operating condition that the photovoltaic module 200 is not in a short circuit state, the auxiliary source circuit 140 is not reset, and the switching transistor is locked in the off state. FIG. 12 (b) shows an operating condition that the photovoltaic module 200 is not in a short-circuit state (the short circuit is relieved), the auxiliary source circuit 140 is reset, and the switching transistor is in an on state. FIG. 12 (c) shows an operating condition that the bus of the photovoltaic module 200 is in the short circuit state, the auxiliary source circuit 140 is reset, and the switching transistor is turned on instantaneously and turned off immediately.

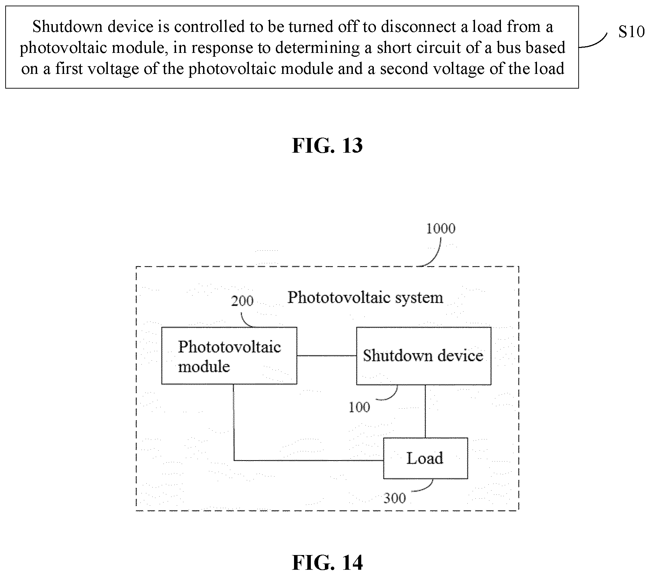

FIG. 13 is a flowchart of a control method for a shutdown device according to an embodiment of the present disclosure.

As shown in FIG. 13, the control method for the shutdown device includes step S10.

In step S10, the shutdown device is controlled to be turned off to disconnect a load from a photovoltaic module, in response to determining a short circuit of a bus based on a first voltage of the photovoltaic module and a second voltage of the load.

In some embodiments of the present disclosure, after controlling the shutdown device to be turned off, the method further includes: controlling the shutdown device to be turned on to connect the load with the photovoltaic module, in the case that the short circuit of the bus is relieved and the auxiliary source circuit is reset.

In some embodiments of the present disclosure, after controlling the shutdown device to be turned off, the method further includes: controlling the shutdown device to be turned off after turned on instantaneously, in the case that the short circuit of the bus is unrelieved and the auxiliary source circuit in the shutdown device is reset.

FIG. 14 is a structural block diagram of a photovoltaic system according to an embodiment of the present disclosure.

As shown in FIG. 14, the photovoltaic system 1000 includes: a photovoltaic module 200, a load 300, and the shutdown device 100 described in the above embodiments.

In some embodiments, as shown in FIG. 1 (a) and FIG. 1 (b), the number of photovoltaic modules 200 and the number of shutdown devices 100 are more than one. Multiple shutdown devices 100 and multiple photovoltaic modules 200 are in one-to-one correspondence.

A shutdown device, a control method for the shutdown device, and a photovoltaic system are provided in the embodiments of the present disclosure. The shutdown device is provided for a corresponding photovoltaic module, and the short circuit of the photovoltaic module is determined by monitoring the voltages of the photovoltaic module and the load. The photovoltaic module is disconnected from the load when it is determined that the short circuit occurs. The switching circuit is locked in the off state by setting the auxiliary source circuit after the photovoltaic module is disconnected with the load. The photovoltaic module may resume power supply to the load in response to determining that the short circuit is relieved and the auxiliary source circuit is reset. That is, the present disclosure has the advantages of a wide application range, which will not be limited by a short-circuit position. In addition, the present disclosure has a driving locking function and a reset function. It should be noted that, the logic and/or the steps illustrated in the flowcharts or described in other ways herein, for example, may be considered as a sequence list of executable instructions for realizing logic functions, and can be specifically implemented in any computer readable medium for the use by an instruction execution system, apparatus or device (e.g., a computer-based system, a system including a processor, or other system capable of reading instructions from the instruction execution system, apparatus or device and executing the instructions), or for the use in combination with the instruction execution system, apparatus or device. The "computer-readable medium" may be any device containing, storing, communicating, propagating or transmitting a program for use by the instruction execution system, apparatus or device or in combination with the instruction execution system, apparatus or device. More specific examples (i.e., a non-exhaustive list) of the computer-readable medium include: an electrical connection part (e.g., an electronic device) with one or more wires, a portable computer disk case (e.g., a magnetic device), a random-access memory (RAM), a read-only memory (ROM), an erasable programmable read-only memory (EPROM or a flash memory), a fiber optic device, and a portable disk read-only memory (CDROM). In addition, the computer readable medium may even be a piece of paper or other suitable medium on which the program is printed. Since that the program can be obtained electronically, for example, by optically scanning the paper or the other medium followed by editing, interpreting or, if necessary, by other suitable processing, and then stored in the memory.

It should be understood that embodiments of the present disclosure may be implemented in hardware, software, firmware, or a combination thereof. In the above embodiments, steps or methods may be implemented by software or firmware stored in the memory and executed by a suitable instruction execution system. For example, the steps or methods are implemented in hardware, as the same in another embodiment, using any one or a combination of the following technologies known in the field: a logic circuit with a logic gate for implementing logic functions on a data signal, a specialized integrated circuit with a suitable combinational logic gate, a programmable gate array (PGA), a field programmable gate array (FPGA) and the like.

Any reference in this specification to "an embodiment", "some embodiments", "example", "specific embodiment" and "some examples", etc. means that a particular feature, structure, or characteristic described in connection with the embodiment is included in at least one embodiment of the present disclosure. In this description, schematic expressions of the above terms do not necessarily refer to the same embodiment or example. Furthermore, the specific features, structures, materials or characteristics described may be combined in any suitable manner in any one or more embodiments or examples.

In the description of the present disclosure, it should be understood that the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. indicates orientation or positional relationship based on the orientation or positional relationship shown in the drawings, and is only for the convenience of describing the present disclosure and the simplified description, rather than indicating or implying that the device or element referred to has to have a specific orientation, and is constructed and operated in a specific orientation, and therefore cannot be understood as a limitation to the present disclosure.

In addition, the terms "first", "second" and the like are for purpose of description, and should not be interpreted as indicating or implying relative importance or implying the number of the indicated technical features. Therefore, features defined with "first" and "second" may explicitly or implicitly include at least one of the features. In the description of the present disclosure, the term "multiple/plurality of" means at least two, such as two, or three, unless clearly defined otherwise.

In the present disclosure, unless clearly specified or defined otherwise, the terms such as "assembling", "connected", "connection" and "fixation" should be understood in a broad sense. For example, "connection" may be a fixed connection, a detachable connection, or connection as an integral, may be a mechanical connection or an electrical connection, may be a direct connection, an indirect connection via an intermediate medium, or internal communication between two components or interaction relationship between two components, unless clearly defined otherwise. Those skilled in the art may understand meanings of the foregoing terms in the present disclosure according to specific conditions.

Unless expressly stated and limited otherwise, a first feature arranged "above" or "below" a second feature indicates that the first feature is in direct contact with the second feature, or is in indirect contact via an intermediate medium. Moreover, the first feature being "on", "above" and "over" the second feature may indicate that the first feature is directly above or obliquely above the second feature, or simply indicates that the first feature is horizontally higher than the second feature. The first feature being "below", "under" and "beneath" the second feature may indicate that the first feature is directly below or obliquely below the second feature, or simply indicates that the first feature is horizontally lower than the second feature.

Although the embodiments of the present disclosure haven been shown and described above, it should be understood that the above embodiments are exemplary and cannot be understood as a limitation to the present disclosure. Those skilled in the art can make changes, modifications, substitutions and variations to the above embodiments within the scope of the present disclosure.

## Claims

1. A shutdown device, applied to a corresponding photovoltaic module (200), wherein the photovoltaic module (200) is configured to supply power to a load (300), and the shutdown device comprises: a switching circuit (110), a sampling-monitoring circuit (120) and a drive circuit (130), wherein
the switching circuit (110) is arranged in a load circuit comprising the photovoltaic module (200) and the load (300), and is connected to the drive circuit (130);
the sampling-monitoring circuit (120) is connected to the photovoltaic module (200), the load (300) and the drive circuit (130); and the sampling-monitoring circuit (120) is configured to sample a first voltage of the photovoltaic module (200) and a second voltage of the load (300), and to control the switching circuit (110) to be turned off through the drive circuit (130) to disconnect the photovoltaic module (200) with the load (300), in response to determining a short circuit of a bus based on the first voltage and the second voltage.

2. The shutdown device according to claim 1, further comprising:
an auxiliary source circuit (140) connected to the photovoltaic module (200) and the drive circuit (130); and configured to output a steady auxiliary voltage in a case that the photovoltaic module (200) operates normally, and keep outputting the auxiliary voltage in the case of the short circuit of the bus,
wherein the drive circuit (130) is further configured to keep the switching circuit (110) in an turned off state under the auxiliary voltage, after controlling the switching circuit (110) to be turned off.

3. The shutdown device according to claim 2, further comprising: a reset circuit (150) connected with the auxiliary source circuit (140),
wherein the auxiliary source circuit (140) is configured to discharge the auxiliary voltage in a reset process of the reset circuit (150); and
the sampling-monitoring circuit (120) is connected to the auxiliary source circuit (140); and the sampling-monitoring circuit (120) is configured to sample a third voltage output by the auxiliary source circuit (140), and control the switching circuit (110) to be turned on by the drive circuit (130) to connect the photovoltaic module (200) with the load (300), in response to determining from the third voltage that the auxiliary source circuit (140) is reset.

4. The shutdown device according to claim 3, wherein the sampling-monitoring circuit (120) is configured to, in response to determining from the third voltage that the auxiliary source circuit (140) is reset, control the switching circuit (110) to be turned off after turned on instantaneously by the drive circuit (130), in a case that the short circuit of the bus determined based on the first voltage and the second voltage is unrelieved; and keep the switching circuit (110) in an on state by the drive circuit (130), in a case that the short circuit of the bus is determined to be relieved.

5. The shutdown device according to any one of claims 1 to 4, wherein the switching circuit (110) comprises a switching transistor; a control terminal of the switching transistor is connected with the drive circuit (130),
a second terminal of the switching transistor is connected with a positive terminal of the photovoltaic module (200) and a first terminal of the switching transistor is connected with a positive terminal of the load (300); or a first terminal of the switching transistor is connected with a negative terminal of the photovoltaic module (200) and a second terminal of the switching transistor is connected with a negative terminal of the load (300).

6. The shutdown device according to claim 3, wherein the sampling-monitoring circuit (120) comprises:
a first voltage sampling unit (121) connected with the photovoltaic module (200), and configured to sample the first voltage;
a second voltage sampling unit (122) connected with the load (300), and configured to sample the second voltage;
a third voltage sampling unit (123) connected with the auxiliary source circuit (140), and configured to sample the third voltage;
a first comparator (124) connected with the first voltage sampling unit (121), configured to compare the first voltage with a target voltage threshold to obtain a first compared result and output a first comparison signal based on the first compared result;
a second comparator (125) connected with the second voltage sampling unit (122), configured to compare the second voltage with the target voltage threshold to obtain a second compared result and output a second comparison signal based on the second compared result;
a third comparator (126) connected with the third voltage sampling unit (123), configured to compare the third voltage with the target voltage threshold to obtain a third compared result and output a third comparison signal based on the third compared result; and
a logical unit (127) connected to the first comparator (124), the second comparator (125), the third comparator (126) and the drive circuit (130),
wherein the logical unit (127) is configured to output a first level signal to the drive circuit (130) to control the switching circuit (110) to be turned off by the drive circuit (130), in response to determining a short-circuit in the photovoltaic module (200) based on the first comparison signal, the second comparison signal and the third comparison signal, or in response to determining that the short-circuit in the photovoltaic module (200) is relieved and the auxiliary source circuit (140) is not reset; and to output a second level signal to the drive circuit (130) to control the switching circuit (110) to be turned on by the drive circuit (130), in response to determining from the first comparison signal, the second comparison signal and the third comparison signal that the short circuit of the bus is relieved and the auxiliary source circuit (140) is reset.

7. The shutdown device according to claim 6, wherein the logical unit (127) comprises: a first AND gate (1271), a second AND gate (1272), an inverter (1273), and an SR trigger (1274);
wherein the first AND gate (1271) comprises: a first input terminal connected to an output terminal of the first comparator (124), a second input terminal connected to an output terminal of the second comparator (125), and an output terminal connected to an S terminal of the SR trigger (1274),
the second AND gate (1272) comprises: a first input terminal connected to the output terminal of the first comparator (124), a second input terminal connected to an output terminal of the third comparator (126), an output terminal connected to an input terminal of the inverter (1273),
an output terminal of the inverter (1273) is connected to an R terminal of the SR trigger (1274), and
a Q terminal of the SR trigger (1274) is connected to the drive circuit (130).

8. The shutdown device according to claim 6, wherein the sampling-monitoring circuit (120) further comprises: a voltage stabilizer (128), a first resistor (R1), a second resistor (R2) and a third resistor (R3),
wherein a first terminal of the first resistor (R1) is connected to a second terminal of the third resistor (R3) and a cathode of the voltage stabilizer (128),
a first terminal of the third resistor (R3) is connected to the auxiliary source circuit (140),
a second terminal of the first resistor (R1) is connected to a first terminal of the second resistor (R2) and a reference terminal of the voltage stabilizer (128), and
a second terminal of the second resistor (R2) is connected to an anode of the voltage stabilizer (128) and is grounded;
wherein the cathode of the voltage stabilizer (128) is configured to output the target voltage threshold.

9. A control method for the shutdown device, wherein the shutdown device is applied to a corresponding photovoltaic module (200), and is arranged in a load circuit comprising the photovoltaic module (200) and a load (300), and the method comprises:
controlling (S10) the shutdown device to be turned off to disconnect the photovoltaic module (200) with the load, when a bus is determined short-circuited based on a first voltage of the photovoltaic module (200) and a second voltage of the load (300).

10. The method according to claim 9, wherein after controlling the shutdown device to be turned off, the method further comprises:
controlling the shutdown device to be turned on to connect the load circuit, when the bus is determined not short-circuited and the auxiliary source circuit (140) is reset.

11. The method according to claim 9, wherein after controlling the shutdown device to be turned off, the method further comprises:
turning off the shutdown device after shortly turning on the shutdown device, when the bus is determined short-circuited and the auxiliary source circuit (140) in the shutdown device is reset.

12. A photovoltaic system, comprising: a photovoltaic module (200), a load (300), and the shutdown device according to any one of claims 1 to 8.
